# EUROPEAN PATENT APPLICATION

(11) **EP 0 849 794 A1**
(43) Date of publication of application: **24.06.1998**
(21) Application number: 97310419.3
(22) Date of filing: 22.12.1997
(51) Int. Cl.: H01L 23/495

(54) **Fine pitch lead frame**

(30) Priority: 20.12.1996 US 33527 P
(71) Applicant: TEXAS INSTRUMENTS INCORPORATED, Dallas Texas 75265 (US)
(72) Inventor: Zuniga, Edgar R., Sherman, Texas 75092 (US)
(74) Representative: Nettleton, John Victor

(57) **Abstract**

A lead frame (10) for a high component density semiconductor device includes fine pitched lead frame leads (20) that have a reduced thickness and tapered end (22) adjacent the die mount pad (12) of the lead frame. The reduced thickness end (22) has a step down (23) from the portion (25) of the lead frame lead that is not reduced in thickness. The reduced thickness end (22) is connected to bond pads on the semiconductor device either directly or by bond wires.

## Description

### FIELD OF THE INVENTION

The invention relates generally to semiconductor devices, and more particularly to an ultra-fine pitch lead frame for integrated circuits.

### BACKGROUND OF THE INVENTION

Wafer fabrication technology to produce small feature geometries is improving at a faster speed than lead frame manufacturing technologies. Wafer fabrication and wire bonding processes have made possible the construction of integrated circuits with a 4.0 mil bond pad pitch, and is approaching a 3.0 mil pitch. Current lead frame inner lead pitch technology limit is approximately 6.9 mils. This is forcing wire length of up to 220 mils, depending on the package size and lead count. Long wire lengths are detrimental to integrated circuit performance as the impedance of the device is significantly increased. Also, long wires are subject to major yield assembly losses when compared with integrated circuits with shorter wire lengths.

The inner lead pitch of a lead frame is mainly a function of the material thickness. The minimum lead width is limited by the wire bonding technology, wire bonder and capillary tool. This limit is about 4.0 mils. The minimum inner space is approximately equal to the material thickness multiplied by a factor k that is a function of the lead frame technology. This factor is a function of the resist gap and resist thickness for the etch process. For a stamping process, the factor is a function of the cutting tool accuracy and tool cost. Fine pitch lead frames are mainly constructed using etch technology. This is because of the lower initial tooling cost, smaller geometry capability and greater flexibility in routing the lead fingers. The factor k for etched lead frames is approximately 0.75 of the material thickness.

There are several technologies in use for reducing the distance between the lead frame inner leads and the integrated circuit bonding pads. One of the most common technologies consists of attaching an interposer between the lead frame inner leads and the semiconductor chip. The interposer is usually made of the same material used in the fabrication of printed circuit boards. The interposer can be made of any material as long as it can be electrically isolated from the lead fingers and is compatible with the physical and mechanical characteristics of the integrated circuit chip and other packaging materials, including lead frames and die attach material.

### SUMMARY OF THE INVENTION

The present invention comprises a fine pitch lead frame for use with a high component density semiconductor circuit package. The lead frame has a plurality of leads around the lead frame die mount pad. Each lead has a non-reduced thickness portion and a reduced thickness portion, the reduced thickness portion having a tapered end adjacent the die mount pad.

### BRIEF DESCRIPTION OF THE DRAWINGS

The present invention will now be further described by way of example, with reference to the accompanying drawings in which:
Fig. 1 shows a lead frame with fine pitch leads;
Fig. 2 shows the spacing used with fine pitched leads;
Fig. 3 is a table showing minimum lead spacing, width and pitch for several material thicknesses:
Fig. 4 shows a fine pitch lead of the present invention;
Fig. 5 is a side view of a semiconductor device with the fine pitch lead in a first configuration;
Fig. 6 is a side view of a semiconductor device with the fine pitch lead in a second configuration; and
Fig. 7 shows a direction connection between the lead of the present invention and the bond pads on a semiconductor die.

### DESCRIPTION OF A PREFERRED EMBODIMENT

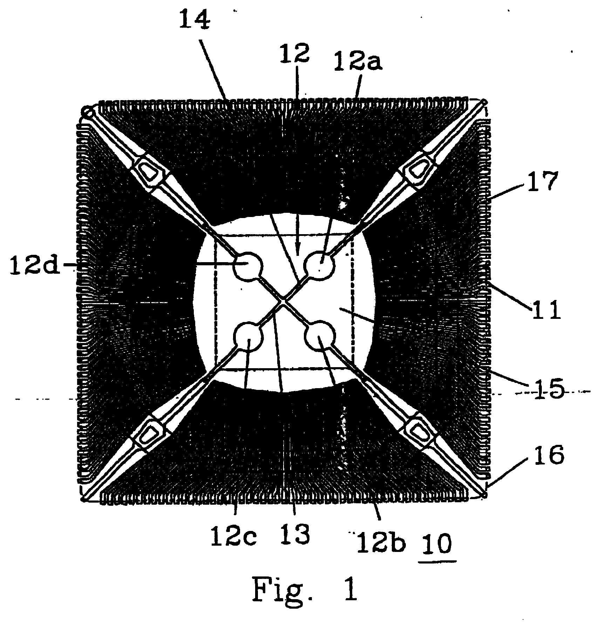

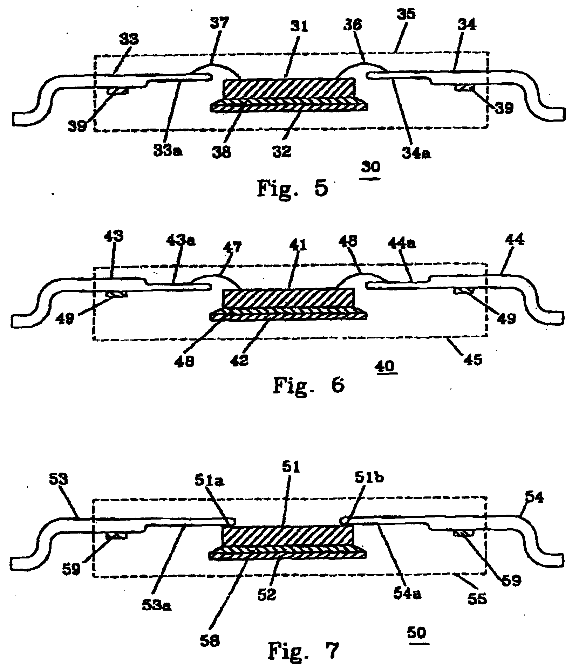

Fig. 1 is a top view of a fine pitch lead frame 10 having a plurality of leads 11. Lead frame 10 has a die mount pad 12 on which a die 15, in dashed lines, is mounted. Die mount pad has, for example, cross arms 13 and 14 which have circular areas 12a-12d. Circular areas 12a and 12c are on arm 13 and circular areas 12b and 12d are on arm 14. Circular areas 12a-12d provide surface areas on which a semiconductor die 15 may be mounted. An adhesive may be applied to arms 13 and 14 and circular areas 12a-12d to hold the semiconductor die in position during assembly and attachment of bond wires (see Figs. 5 and 6) between the lead frame leads and the semiconductor die. An outline 16 shows the edge of the device package. A lead frame lead stabilizer tape 17 is shown. Stabilizer 17, may be, for example, an adhesive tape which prevents movement of the leads until the device is packaged.

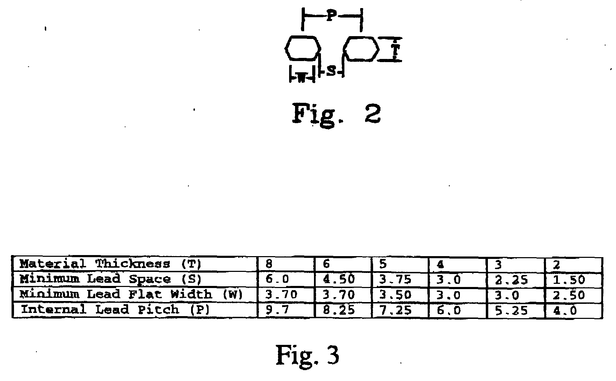

Fig. 2 is a cross-sectional view of two adjacent lead frame leads showing the various dimensions that have to be considered in reducing lead pitch in ultra-fine pitch lead frames. P is the lead pitch, which is measured from the center of one lead to the center of an adjacent lead. W is the lead width, T is the lead thickness and S is the space between leads.

Fig. 3 is a table showing the minimum lead space S and minimum lead width W, and internal lead pitch P for several material thicknesses T. The minimum inner space S is approximately equal to the material thickness T multiplied by a factor k that is a function of the lead frame technology. This factor is a function of the resist gap and resist thickness for the etch process. For a stamping process, the factor is a function of the cutting tool accuracy and tool cost. Fine pitch lead frames are mainly constructed using etch technology. This is because of the lower initial tooling cost, smaller geometry capability and more flexibility in routing the lead fingers. The factor k for etch lead frames is approximately 0.75 of the material thickness T. Thinner material thickness T, permits smaller lead space S, lead width W, and lead pitch P, allowing for more leads, or smaller packages when utilizing leads according to the present invention. From Fig. 3, it is seen that a lead pitch of 5.25 mils can be achieved with a material thickness of 3 mils. This is an improvement over current technology that has a limit of minimum lead pitch of approximately 6.9 mils.

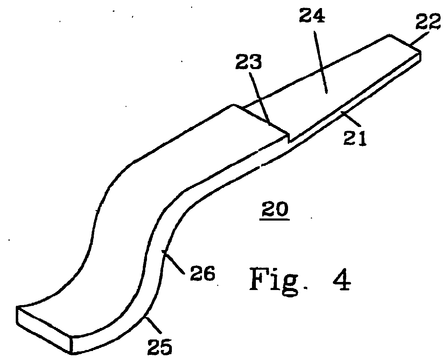

Fig. 4 shows an isometric view of a lead. Lead 20 having a reduced thickness section 24 that tapers from the full width of lead 20 at step-down 23 to an inner end 22. The thickness 21 of reduced section 24 has, for example, a thickness from about 2 mils to 3 mils, whereas the thickness 26 of outer end 25 is, for example, about 6 mils. Reduced section 24 may be formed by either a mechanical or chemical process. For example, two material thicknesses can be made by rolling, coining, forging or extrusion, or a combination of coining and grinding. Reduced section 24 may also be made by chemical etching.

The step-down at 23 is located where the lead pitch P is measured since the tapered portion of lead 20 begins at step-down 23 and is tapered to end 22. With a material thickness T of 5 mils, the pitch is about 7.25 mils at step-down 23. With a material thickness of about 3 mils, the internal pitch P of the leads is about 5.25 mils.

Lead frame lead 20 reduces the gap between the lead frame inner lead pitch and the integrated circuit bond pad pitch, resulting in better device performance, higher assembly yields and lower assembly costs. Lead frame lead 20 can be used in any integrated circuit that requires the use of a metal lead frame and allows direct connection of the integrated circuit to the metal lead frame, eliminating wire bonding between the integrated circuit die and the lead frame lead.

Fig. 5 is a cross-sectional view of a semiconductor device 30 showing two leads 33 and 34 of the present invention with lead 33 attached to die 31 by bond wire 37 and lead 34 is attached to die 31 by bond wire 36. Die 31 is mounted on bond pad 32 with a bonding adhesive 38. The outline of package 35 is shown in dashed lines. Bond wire 36 is attached to the back side of reduced section 34a. Similarly bond wire 37 is attached to the back of reduced section 33a. Adhesive tape 39 is utilized to hold the leads in place during assembly

Fig. 6 is a cross-sectional view of a semiconductor device 40 showing two leads 43 and 44 of the present invention with lead 43 attached to die 41 by bond wire 47 and lead 44 is attached to die 41 by bond wire 48. Adhesive stabilizer tape 49 is shown attached to the under side of the leads. However, tape 49 may be attached to the top side of the leads. Die 41 is mounted on bond pad 42 with a bonding adhesive 48. The outline of package 45 is shown in dashed lines. Bond wire 47 is attached to the reduced section side 43a of lead 43. Similarly, bond wire 48 is attached to the reduced section side 44a of lead 44.

Fig. 7 shows an embodiment of semiconductor device 50 in which leads 53 and 54 are formed with the reduced section stepped-down areas on the underside of each lead and held in place by adhesive tape 59. Semiconductor die is bonded to die pad 52 with a bonding adhesive 58. Lead 53 has the inner end of reduced section 53a over and in contact with bond pad 51a on semiconductor die 51, and lead 54 has the inner end of reduced section 54a over and in contact with bond pad 51b. This bonding method eliminates the use of bond wire and allows the direction connection of the lead frame leads to the bond pads on the semiconductor die.

## Claims

1. A lead frame for an integrated circuit package, comprising:
a die mount pad;
a plurality of leads around said lead frame, each lead having a normal thickness portion and a reduced thickness portion, said reduced thickness portion having a tapered end adjacent said die mount pad.

2. The lead frame according to Claim 1, wherein said reduced thickness end has a thickness of about 50% of the thickness of the lead frame.

3. The lead frame according to Claim 1 or Claim 2, wherein said reduced thickness end of the lead is in the range of 2 to 3 mils thick.

4. The lead frame according to any of Claims 1 to 3, wherein said reduced thickness end includes a step-down region, stepped-down from the normal thickness portion.

5. The lead frame according to any of Claims 1 to 4, wherein said reduced thickness portion of said lead frame lead includes a surface stepped-down from the surface of the normal porticn, and the stepped-down portion is dispopsed at a top surface of the lead frame lead.

6. The lead frame according to any of Claims 1 to 4, wherein said reduced thickness portion of said lead frame lead includes a surface stepped-down from the surface of the non-reduced portion, and the stepped-down portion is disposed at a bottom surface of the lead frame lead.

7. The lead frame according to any of Claims 1 to 6, wherein in combination with a semiconductor device having bond pads thereon, each bond pad is electrically connected to the reduced thickness and tapered end of the lead frame by a bond wire.

8. The lead frame according to any of Claims 1 to 6, wherein in combination with a semiconductor device having bond pads thereon, each bond pad is directly electrically connected to the reduced thickness and tapered end of the lead frame.

9. The lead frame according to any of Claims 1 to 8, wherein said die mount pad comprises a plurality of crossed arms with a pair of increased size areas on each arm.

10. The lead frame according to any of Claims 1 to 9, wherein said lead frame is a fine pitch lead frame for use with a high component density integrated circuit package.

11. A lead frame for an integrated circuit package, comprising:
a die mount pad;
a plurality of leads around said lead frame, each lead having a normal thickness outer portion, and a reduced thickness inner portion adjacent to the die mount pad, said reduced thickness portion having a stepped-down surface from one surface of the normal portion providing the reduced thickness, and the inner portion of a lead tapers to a reduced width end from the stepped-down surface to an end adjacent to the die mount pad.

12. The lead frame according to Claim 11, wherein said reduced thickness end has a thickness of about 50% of the thickness of the lead frame.

13. The lead frame according to Claim 11 or Claim 12, wherein said reduced thickness end of the lead is in the range of 2 to 3 mils thick.

14. The lead frame according to any of Claims 11 to 13, wherein said stepped-down portion is disposed at a top surface of the lead frame lead.

15. The lead frame according to any of Claims 11 to 13, wherein said stepped-down portion is disposed at a bottom surface of the lead frame lead.

16. The lead frame according to any of Claims 11 to 15, wherein in combination with a semiconductor device having bond pads thereon, each bond pad is electrically connected to the reduced thickness and tapered end of the lead frame by a bond wire.

17. The lead frame according to any of Claims 11 to 15, wherein in combination with a semiconductor device having bond pads thereon, each bond pad is directly electrically connected to the reduced thickness and tapered end of the lead frame.

18. A lead frame for an integrated circuit package, comprising:
a die mount pad, including at least two crossed arm members intersecting each other at a mid point of each crossed arm, the intersection of the crossed arms dividing each arm into a first and second part, and a plurality of mounting areas, there being at least one mounting area on each of said first and second parts of said arms;
a plurality of leads around said lead frame, each lead having a normal thickness outer portion, and a reduced thickness inner portion adjacent to the die mount pad, said reduced thickness portion having a stepped-down surface from one surface of the normal portion providing the reduced thickness, and the inner portion of a lead tapers to a reduced width end from the stepped-down surface to an end adjacent to the die mount pad.
